# EUROPEAN PATENT APPLICATION

(11) **EP 1 458 016 A1**
(43) Date of publication of application: **15.09.2004**
(21) Application number: 03290610.9
(22) Date of filing: 12.03.2003
(51) Int. Cl.: H01L 21/02, C23C 16/40, G02B 6/00, C03B 37/01, C07F 5/00, C03C 25/22, C03C 25/60, C07F 15/00

(54) **Rare-earth complexes for the manufacture of optical fibers**

(71) Applicant: CORNING INCORPORATED, Corning, N.Y. 14831 (US)
(72) Inventor: Roux, Stéphane, 94220 Chareton le Pont (FR); Arnoud, Olivier, 94300 Vincennes (FR); Lafosse, Xavier, 91190 Gif-sur-Yvette (FR)
(74) Representative: Poole, Michael John

(57) **Abstract**

The invention is directed to a family of organo-metal complexes having a metal atom coordinated to charged fluorinated ligands and a neutral ligand or ligands. The metals may be lanthanide or transition metals. The complexes according to the invention are of general formula MAₓB_{y}, where A is a charged ligand; B is a neutral ligand; x=the valence of metal M, typically +3 for lanthanides and +2 or +3 for transition metals; and y=0-3. Typically, for lanthanide metals y=1 or 2 and for transition metals y=0 or 1, although higher values of y can be attained in both cases. Suitable neutral ligands include dimethyl sulfoxide, glyme, and di-, tri- and tetra-glyme. The charged ligands are fluorinated charged ligands selected from the group consisting of 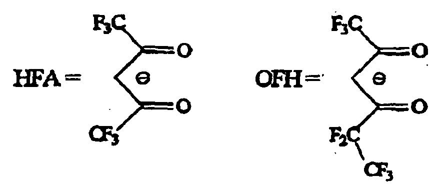 and mixtures thereof.

## Description

### Background

The invention relates to novel compounds having much higher volatility and improved thermal stability than known 6,6,7,7,8,8,8-heptafluoro-2,2-dimethyl-3,5-octanedionato ("FOD") complexes of rare earth elements, for example, Erbium(FOD)₃ (also sometimes written as Er-FOD both herein and in commercial usage). In particular, the invention is directed to novel compounds that can be used in every vapor deposition process used to make optical fibers and devices, and in particular the Outside Vapor Deposition ("OVD") process.

### Prior Art

In recent years, in optical communication systems the use of optical amplifiers has experienced explosive development because it has been recognized that this type of amplifier has numerous advantages over the older, repeater type amplification systems. Rare-earth elements, which are known to have properties useful for optical applications, have been found to be particularly use in such optical amplifier systems. In particular, the use of rare-earth doped fibers and waveguides has increased because of their utility in optical amplifiers and lasers. For example, the telecommunication industry has used erbium-doped fiber amplifiers that conveniently operate at the relative low-loss 1528-1565 nm spectral window. These erbium-doped amplifiers exhibit low cross-talk between signals of different wavelengths, have broad gain bandwidth (approximately 30 nm), and gain that is not polarization dependent. To compensate for the decrease in intensity due to attenuation in transmission fibers and waveguides, and insertion losses due to various optical components, such rare-earth amplifiers are increasingly needed.

Various rare-earth complexes, RE(FOD)₃, have been used in the manufacturing of rare-earth doped optical fibers and other optical elements. However, in many instances particular selected complexes have been found to exhibit erratic behavior. As a result, the concentration of the rare-earth metals in different fiber batches has been found to vary from 1000 ppm to 4000 ppm. Because of this variation, the manufacturing process for rare-earth doped optical fibers must be tightly controlled in order to provide batch-to-batch consistency. Investigations have been carried out using different complexing agents and it was found that the crown ethers (cyclic polyethers) and β-diketones form complexes with rare earth elements and that such that such complexes are used in the fiber manufacturing process. However, problems still exist, particularly with regard to batch-to-bath metal concentration variability.

The field of volatile metal complexes is quite large. The type of complex used depends, among other factors, on the nature of the metal or metalloid being used and the application. However, there exist three broad categories:
1. Alkali, alkali-earth, lanthanides (rare-earth) and actinide metals.
   These are always oxophilic and electropositive metals. Consequently, they are always in cationic form (+I, +II, and +III). They are chelated by anionic ligands, and by neutral ligands containing oxygen and nitrogen. The chelation is accomplished by electronic lone pairs such as exist in ethers, amines, sulfoxides, phosphine-oxides and similar substances.
2. Transition metals.
   These metal form complexes in either the cationic or the neutral state; for example Fe(NH₃)₆⁺⁺ and Fe(CO)₅. The choice of neutral ligands that can be used with these metals is more varied, encompassing, for example, ethers, amines, sulfides, phosphines, sulfoxides, phosphine-oxides, arsines, arsine-oxides, carbon monoxide
3. Metalloids.
   The complexes formed from metalloids are more like covalent molecular edifices than like coordination compounds such as Fe(NH₃)₆⁺⁺ and Fe(CO)₅.

Alkali, alkali-earth, lanthanides volatile metal complexes are studied for a number of years. The first such volatile complexes were formed using magnesium, fluorinated hexafluoroacetone and one additional neutral ligand such as glyme (ethylene glycol dimethylether), and were patented in 1985 (U.S. Patent 4,558,144). J.A.T. NORMAN et al, European Patent Application No. 460627, disclosed similar work. In addition, over the last 1-15 years the interest in high T_{c} superconductor ceramics led to substantial progress in the field of CVD (chemical vapor deposition) processes. This has resulted in a number of patents and publications deal with the making, the tailoring, and the uses of volatile metal complexes. [See K.K. Uei et al., *"Metal-organic chemical vapor deposition of lanthanide element-containing semiconductor".* Jpn. Kokai Tokkyo Koho, 63184324 (1988), p. 10 pp; F.G.N. Cloke, *"Volatile lanthanide complexes useful for chemical vapor deposition".* Eur. Pat. Appl., 295829 (1988). p. 5 pp; H.C. Holzschuh et al., *"Thin films of barium, yttrium, europium, erbium, and copper oxides prepared by plasma-enhanced CVD",* Mod. Phys. Lett. B. 1988.2(11-12): p. 1253-7; A. Weber et al., *"Thin lanthanum oxide and rare-earth oxide films by PECVD of beta-diketonate chelate complexes",* Mod. Phys. Lett. B. 1989.**3**(13): p. 1001-8; and V.M. Vorotyntsev et al., *"Initial volatile substances for producing superconducting films by chemical vapor-phase deposition",* Vysokochist. Veshchestva. 1989(4): p. 108-16.] The importance of the solvent and of water in the formation of the complexes water was studied by D.J. Otway et al., "An investigation into the role of incorporated solvent (EOH/H₂O) molecules on the structure of Group 2 metal bis(beta-diketonate) complexes: ramifications for CVD precursors of electronic materials." Mater. Res. Soc. Symp. Proc. 1996 415 (Metal-Organic Chemical Vapor Deposition of Electronic Ceramics II), pp. 105-110.

In addition to the above patents and publications, there have been a number of patents relating to the glyme adducts of lanthanide metals. These include US 4,257,955, 5,657,156 and 5,162,508; EP Patent Application Publication Nos. EP 0 321 353 and EP 1 013 740; and PCT International Patent Application Publication Nos. WO 88/08422, 92/05807, 94/27977, 95/28392, 96/26182, 99/12939 and 01/21667. Patents related to rare earth metal glyme-diketonate complexes include US5453494 (A1X6) to Kirlin; US 5,504,195 to Leedham; GB 2,274,456 A1 to Leedham; and EP 0 527 661 A1 to Cole-Hamilton.

However, while there has been extensive research directed to volatile lanthanide metal complexes. The need exists for improved complexes having much higher volatility and improved thermal stability.

### Summary Of The Invention

The invention is directed to novel lanthanide and transition metal complexes, and in particular to lanthanide complexes that can serve as replacement for lanthanide(FOD) complexes. In particular, the invention is directed to novel complexes of erbium that can serve as a replacement for Erbium(FOD)₃ complexes.

The invention is further directed to novel lanthanide complexes that can be used in CVD processes. The invention is also directed to novel lanthanide metal complexes that can be used in the CVD process at lower temperatures without the need for changing process conditions. This will stabilize the process. Transition metals can similarly be used.

The invention is particularly directed to complexes formed by coordination to charged fluorinated ligand and a neutral ligand. The preferred ligands are:
Charged Ligands: 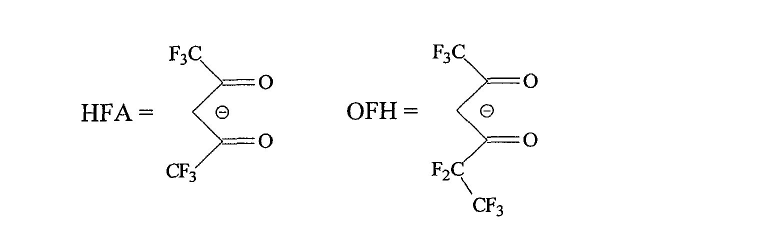
Neutral ligands:

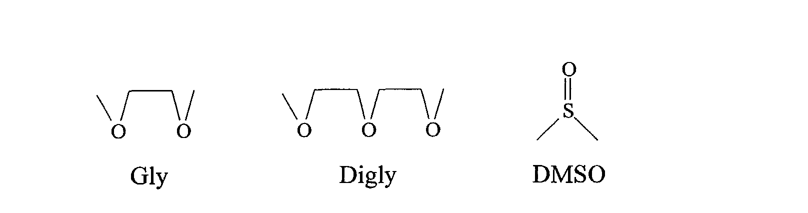

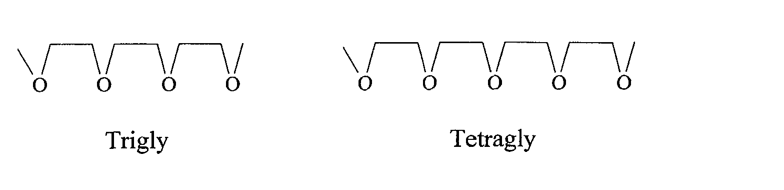

### Brief Description of the Drawings

Figure 1 illustrates the volatilization of different complexes with temperature.
Figure 2 illustrates the charged ligand effect on volatilization of OFA and HFA complexes.
Figure 3 illustrates the neutral ligand effect on volatilization of HFA complexes.
Figure 4 illustrates the corrected volatilization rate vs. Er(FOD)₃.

### Detailed Description of the invention

The invention is directed to a family of organic complexes of metallic elements, and in particular to organic complexes of the lanthanide elements. Of particular value are organic complexes of erbium that can be used in the manufacturing of materials for optical communications systems. The metal-organic complexes of the invention are all quite volatile. Structure-properties relationships were found and the complexes were tailored in order to prepare complexes having the highest possible volatility and greatly improved thermal stability. In another aspect of the invention, a quick and simple experimental procedure was developed for synthesizing the organo-metal complexes. The procedure one which is easy to scale up, allowing for the preparation of larger quantities of complexes.

The family of organo-metal complexes of the invention constitutes a metal atom coordinated to charged fluorinated ligand and a neutral ligand.
Charged Ligands: 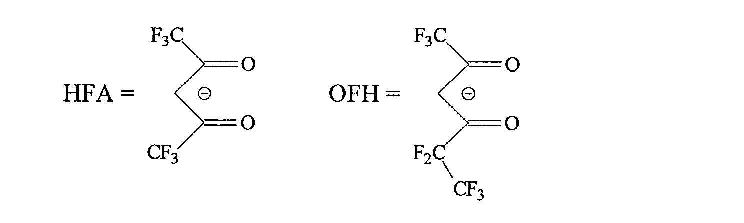
Neutral ligands:

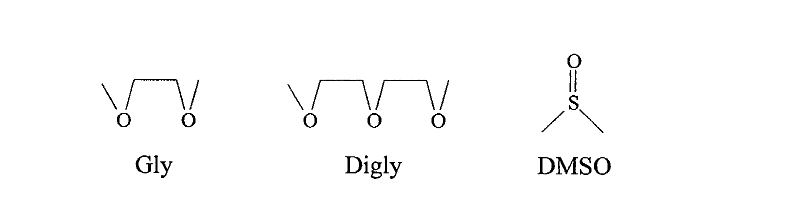

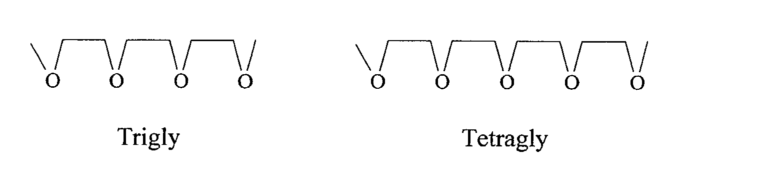

The ligands according to the invention can be use to complex alkali and alkaline earth metals, for example without limitation, sodium, potassium, magnesium, barium, strontium and calcium; transition metals, for example without limitation, iron, vanadium, platinum, manganese, cobalt, nickel and gold; and lanthanide metals, for example without limitation, erbium, neodymium, praseodymium, yttrium, ytterbium and holmium. Of particular importance for optical telecommunication are the lanthanide metal complexes of the foregoing charged and neutral ligands.

In particular, the metal complexes according to the invention are of general formula comprising complexes of general formula MAₓB_{y}, wherein A is a charged ligand; B is a neutral ligand; x = the valence of metal M, typically +3 for lanthanides and +2 or +3 for transition metals; and y = 0-3. Typically, for lanthanide metals y = 1 or 2 and for transition metals y = 0 or 1, although higher values for y can be attained in both cases depending on the number of available coordination sites. For example, the complex Er(HFA)₃(DMSO)₃, where y=3, was prepared as well as Er(HFA)₃(glyme)₂. In addition, one can make complexes in which y = 0; for example, Er(HFA or OFH)₃, Pr(HFA or OFH)₃, Fe(HFA or OFH)₃, and similar lanthanide and transition metal complexes. Thus, for MAₓB_{y} complexes
(a) M may be a transition metal or a lanthanide metal;
(b) A is a charged ligand selected from the group consisting of 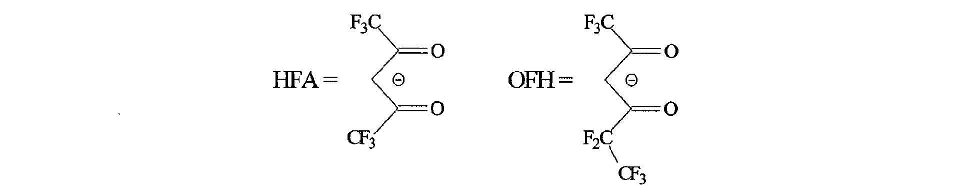 and mixtures thereof; and
(b) B is a neutral ligand selected from the group consisting of 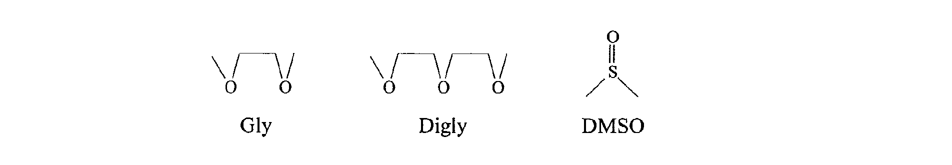 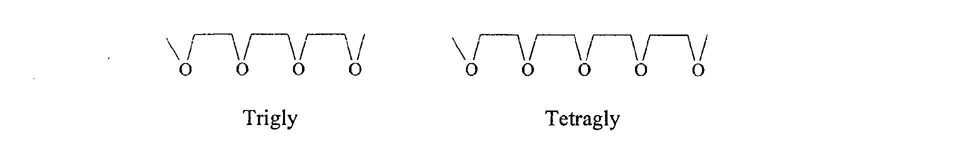 and mixtures thereof.
Lanthanide metal of particular utility, especially relating to optical communications devices and elements, dysprosium, erbium, europium, gadolinium, holmium, lanthanum, neodymium, and praseodymium. Transition metals of particular utility include silver, palladium, rhodium, ruthenium, gold, platinum, iridium, osmium, copper, nickel and cobalt.

The metal complexes according to the invention, whether lanthanide or transition metal, can be used to make a variety of items using various techniques known in the arts. For example, they can be used to make optical communication devices and elements such as optical fiber, gratings, lenses, mirrors and other elements whether made of glass or polymeric materials. In some cases the elements of devices can be wholly or partially reflective. They can be used o dope selected elements into various materials formulations and to make coatings. The metal complexes of the invention will this find utility in the semiconductor industry. In the area of optical fibers, the metal complexes according to the invention can be used with virtually any technique, for example, flame hydrolysis deposition, chemical vapor deposition, plasma techniques and other method techniques known to those skilled in the art. The complexes according to the invention are particularly useful in chemical vapor deposition methods.

### General Procedure For preparing Lanthanide Metal Complexes

A solution was prepared containing sodium hydroxide (7.85 mmol, 3eq) in water (10 ml). Subsequently, hexafluoroacetylacetone (HFA, 7.85 mmol, 3eq), erbium(III) chloride hexahydrate (2.62 mmol, leq), dichloromethane (20 ml), and n-ethylene glycol dimethyl ether (glyme (Gly), 2.62 mmol, leq) were added to the sodium hydroxide solution and stirred at room temperature. After 30 minutes of stirring, the mixture was decanted. The pink organic solution is dried and then evaporated under vacuum. A pink erbium complex was obtained in quantitative yield. Similar complexes of other lanthanide metals, for example praseodymium, ytterbium and holmium can be similarly prepared.

### Example 1:

A solution was prepared containing sodium hydroxide (314 mg, 7.85 mmol, 3eq, M = 40 g/mol) in water (10 ml). Subsequently, hexafluoroacetylacetone (1.426ml, 7.85 mmol, 3eq, M = 208.06g/mol, d=1.147) was added and the resulting solution was stirred for 5 minutes. Next, pink solid erbium(III) chloride hexahydrate (1.0g 2.62 mmol, 1eq, M=381.71 g/mol) and 20 ml of dichloromethane were added with stirring to the solution. After 5 minutes, triethylene glycol dimethyl ether (0.474 ml, 2.62 mmol, 1eq, M=178.23, d=0.986) was added and the solution was stirred for an additional 30 minutes. The colorless aqueous layer and the pink organic layer were separated. The pink organic solution was evaporated in vacuum to yield a pink solid Erbium(HFA)₃-Gly complex, m= 2.38g (M = 966.67 g/mol) with 94 % yield.

### Example 2:

A solution was prepared containing sodium hydroxide (6.51 g) in water (100 ml). Subsequently, hexafluoroacetylacetone (34.51g) in dichloromethane (200 ml) was added in a dropwise manner and stirred until the mixture becomes whitish. Next, a solution of solid erbium(III) chloride hexahydrate (20.68 g) in water (100 ml) was poured in the foregoing mixture. After stirring for 5 minutes, diethylene glycol dimethylether (7.27 g) was added and the resulting mixture was stirred for 30 minutes. At this time, organic phase was pink and the water phase was almost colorless. Organic phase was decanted then washed with 2 x 200 ml of deionized water. The organic phase was then crudely dried using a water separator. Next the pink organic phase was evaporated to dryness in vacuum to give a pink liquid which solidified on cooling. Solid m = 47.44 g (M = 966.67 g/mol) with 95 % yield.

### Example 3

Using the procedure described in Example 1, an erbium complex is prepared using OFH and glyme (Gly).

### Example 4

Using the procedure described in Example 1, a neodymium complex is prepared using OFH and tetraglyme (Tetragly).

### Example 5

Using the procedure described in Example 1, the erbium complex Er(HFA)₃(DMSO)₃ was prepared using HFA and DMSO (dimethylsulfoxide).

### Characterization

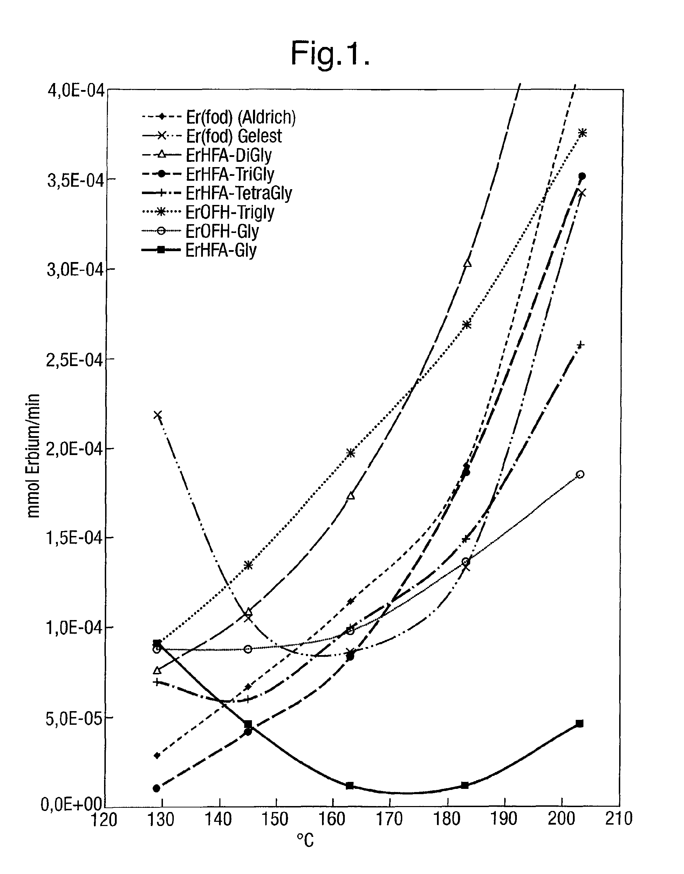

The erbium complexes were evaluated using thermogravimetric analysis (TGA) to determine weight-loss % with temperature and weight-loss % with time at constant temperature. The curves were normalized with respect to molecular weight in order to compare the efficiency of erbium transport by the complexes. Although the first experiment was slightly inaccurate because equilibrium was not reached, it nevertheless gave very good indications of product properties. The second set of experiment was able to measure precisely the weight loss with time at constant temperature. The results are shown in Figures 1, 2 and 3 and in Table 1.

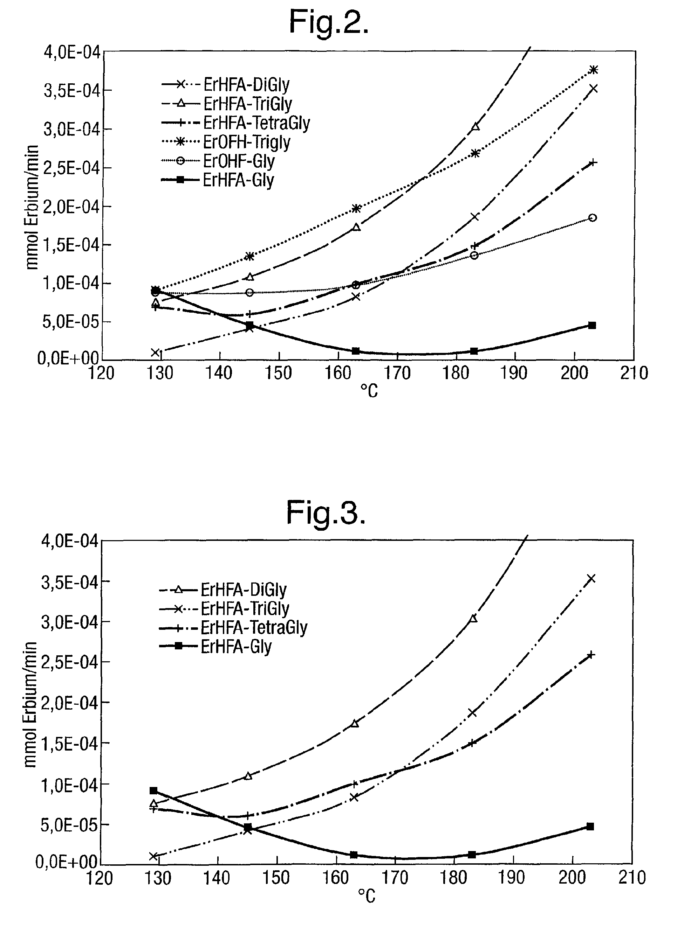

The results are presented in Figures 1,2, and 3, and in Table 1. It is worth commenting that:
1. Erbium-FOD from different manufacturers shows noticeable differences. In particular, the product from Gelest has a volatility that first decreases with increasing temperature, and then increases again. This is due to an excess of free very volatile FOD (see GC-MS experiment in annexes 1): at low temperature the very volatile FOD evaporates. When we arrive at higher temperature there is no free FOD remains, so volatility is lower and starts to increases at much higher temperature. Nevertheless, volatility is quite different at extreme temperature.
2. Two products were of low volatility: Er(HFA)₃-Gly and Er(HFA)₃-(OP-nOct₃)₂.
3, With the same neutral ligand (except diglyme) volatility is ranked as: OFH>HFA. (See Figure 2.)
3. With the same charged ligand, volatility is ranked as: Digly > DMSO > Trigly > Tetragly > Gly. (See Figure 3 and Table 1.)

The most volatile product obtained is this time is Er(HFA)₃-Digly. This product is 2.53 more volatile than Erbium-FOD at a 20°C lower process temperature and 4.6 more volatile than Erbium-FOD at 150°C.

Referring to the Figures, in the Figures the various complexes according to the invention are referred to using a shorthand notation. For example, it is to be understood that that shorthand notation Er(fod) or Er-FOD or ErHFA-TriGly (or ErHFA-Trigly, for example) signifies the complexes Er(FOD)₃ and Er(HFA)₃-Digly, respectively. Similar shorthand notation is used for other complexes.

Referring now to Figure 1, for the product ErHFA·Gly, the curve should not be as shown, but should be similar to the other 'glyme" materials. The anomaly is due to the presence of a small excess of glyme, which is very volatile. When excess glyme is not presence, the volatility curve stabilizes and then goes up again.

**Table 1:**

| Volatilization in mol/min, 14 hour or 40 hour duration | | | |
|---|---|---|---|
| | Volatilization at 100°C | Volatilization at 130°C | Volatilization at 150°C |
| Er(HFA)₃-Digly | 2.2^{E}-09 | 1.36^{E}-08 | 2.47^{E}-08 |
| Er(HFA)₃-Trigly | - | 8.40^{E}-09 | 7.27^{E}-09 |
| Er(HFA)₃-DMSO₃ * | - | 2.65^{E}-09 | 1.00^{E}-08 |
| Er(OFH)₃-Digly | 7.8^{E}-10 | 6.71^{E}-09 | 1.28^{E}-08 |
| Er(OFH)₃-DMSO₃ * | - | 3.6^{E}-09 | |
| **Er(FOD)**_{**3**} | | | **5.36**^{**E**}**-09** |

| | | | |
|---|---|---|---|
| * = assumed stoichiometry nomenclature, e.g., 2.2^{E}-09 = 0.0000000022 (mol/min) | | | |

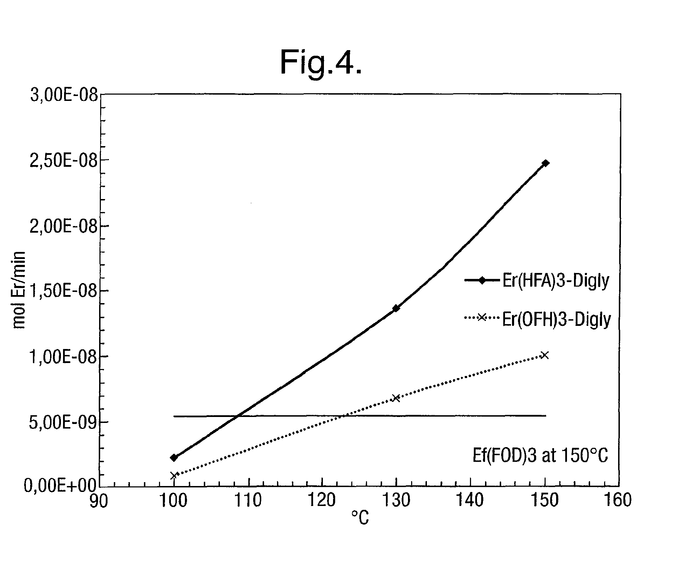

Referring to Figure 4, the Figure shows the volatilization rates measured at constant temperature for 14 hours or 40 hours. Interpolation indicates that best candidate for replacing the present erbium complex, Er(FOD)₃ , is Er(HFA)₃-Digly. Er(HFA)₃-Digly may be used at a temperature of approximately 108°C instead of 150°C required for Er(FOD)₃. For other products according to the invention, their use temperature is indicated as being around 123°C. The high volatility of the complexes of the invention is clearly due to the structure of these new complexes and not to a slightly reduced molecular weight (the best product being about 10% less than Er(FOD)).

The products of the invention, and especially the Erbium-HFA-Diglyme complex, are more stable at processing temperatures than Erbium-FOD as evidenced by the experimental results. In particular, the products of the invention exhibit volatility at much lower temperatures, thus making it easier to control the complex addition rate during processing, and have the added benefit of a much improved temperature stability and being non-hygroscopic. Er-FOD is hygroscopic, as are other metal-FOD complexes such as Ag-FOD, Eu-FOD, Dy-FOD, Gd-FOD and similar complexes. In addition, Ag-FOD is light sensitive and other metal-FOD complexes may similarly be light sensitive (e.g., Pd-FOD, Rh-FOD and others. The higher volatility of the complexes of the invention improve processing control and improved manufacturing yields through a decrease in the batch-to-batch erbium concentration presently experiences in both the preforms and the resulting optical fiber. The products of the invention will also make possible the manufacturing of highly doped erbium fiber for L-Band amplification.

The foregoing examples of specific compositions, processes, articles and/or apparatus employed in the practice of the present invention are, of course, intended to be illustrative rather than limiting, and it will be apparent the numerous variations and modification of these specific embodiments may be practiced within the scope of the appended claims.

*Any discussion of the background to the invention herein is included to explain the context of the invention. Where any document or information is referred to as "known", it is admitted only that it was known to at least one member of the public somewhere prior to the date of this application. Unless the content of the reference otherwise clearly indicates, no admission is made that such knowledge was available to the public or to experts in the art to which the invention relates in any particular country (whether a member-state of the PCT or not), nor that it was known or disclosed before the invention was made or prior to any claimed date. Further, no admission is made that any document or information forms part of the common general knowledge of the art either on a world-wide basis or in any country and it is not believed that any of it does so.*

## Claims

1. Metal complexes comprising complexes of general formula MAₓB_{y}, wherein M is a transition metal or a lanthanide metal, x = the valence state of the metal, and y = 0-3 for lanthanide metals and for transition metals depending on the available coordination sites;
***characterized in that***
(a) A is a charged ligand selected from the group consisting of 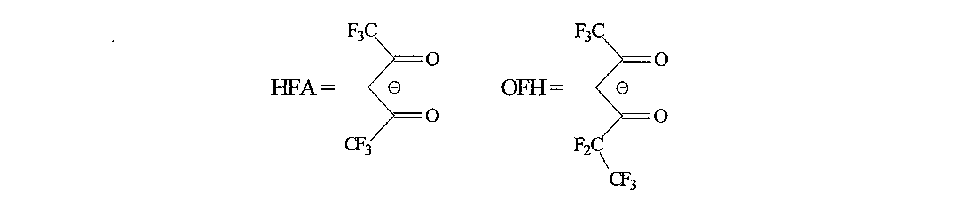 and mixtures thereof; and
(b) B is a neutral ligand selected from the group consisting of 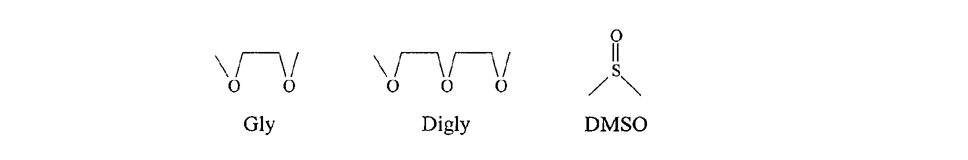 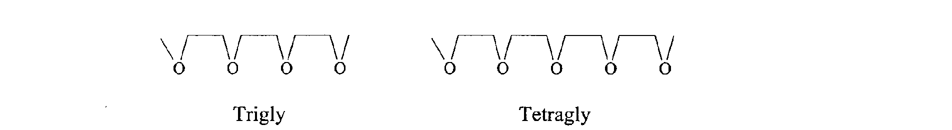 and mixtures thereof.

2. The metal complexes according to claim 1, further **characterized in that** the metal is a lanthanide metal and y = 1-3.

3. The metal complexes according to claim 1, further **characterized in that** the lanthanide metal is dysprosium, erbium, europium, gadolinium, holmium, lanthanum, neodymium, and praseodymium.

4. The metal complexes according to any one of claims 1-3, further **characterized in that** the ligand A is HFA and ligand B is glyme, diglyme or triglyme

5. The metal complexes according to any one of claims 1-3, further **characterized in that** the ligand A is OFA and ligand B is glyme, diglyme or triglyme.

6. The metal complexes according to any one of claims 1-3, further **characterized in that** ligand A is HFA or OFH, ligand B is DMSO and y = 3.

7. The metal complexes according to claim 1, further **characterized in that** the metal is a transition metal transition metal selected from the group consisting silver, palladium, rhodium, ruthenium, cobalt, nickel, copper, gold, platinum, iridium, osmium and rhenium.

8. The use of a metal complex claimed in any one of claims 1-7 as a volatile metal complex to introduce the said lanthanide metal or transition metal in a process for making a doped glass material.

9. A method of making a glass material containing a selected metal, said method being any method known in the art in which a volatile metal complex is used to add such metal to the glass material, and said metal is a transition metal or a lanthanide metal,
***characterized in that***
(a) the transition and lanthanide metal complex is of general formula MAₓB_{y}, wherein x = the valence state of the metal, and y = 0-3 for lanthanide metals and for transition metal depending on the available coordination sites:
(b) A is a charged ligand selected from the group consisting of 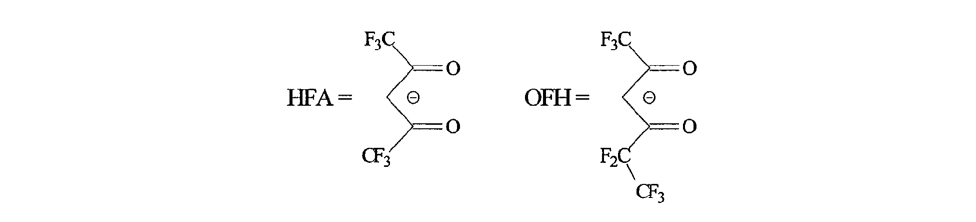 and mixtures thereof; and
(c) B is a neutral ligand selected from the group consisting of 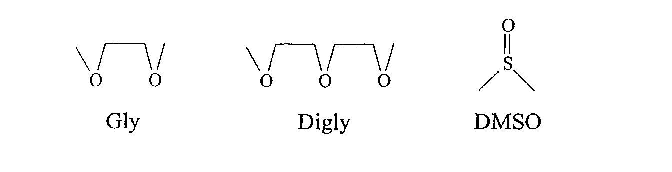 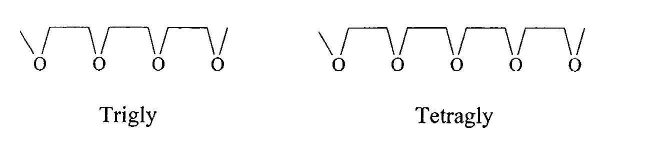
and mixtures thereof.

10. The method according to claim 9, further **characterized in that** the metal is a lanthanide metal.

11. The method according to claim 9 or claim 10, further **characterized in that** y = 1-3.

12. The method according to any one of claims 9-11, further **characterized in that** the lanthanide metal is dysprosium, erbium, europium, gadolinium, holmium, lanthanum, neodymium, and praseodymium.

13. The method according to any one of claims 9-12, further **characterized in that** the ligand A is HFA and the ligand B is glyme, diglyme or triglyme.

14. The method according to any one of claims 9-12, further **characterized in that** the ligand A is OFH and ligand B is glyme, diglyme or triglyme.

15. The method according to any one of claims 9-12 wherein ligand A is HFA or OFH, ligand B is DMSO and y = 3.
